# EUROPEAN PATENT APPLICATION

(11) **EP 0 803 955 A2**
(43) Date of publication of application: **29.10.1997**
(21) Application number: 97302767.5
(22) Date of filing: 23.04.1997
(51) Int. Cl.: H02H 9/04

(54) **An electrostatic discharge protection circuit**

(30) Priority: 25.04.1996 US 16185
(71) Applicant: TEXAS INSTRUMENTS INCORPORATED, Dallas Texas 75265 (US)
(72) Inventor: Teggatz, Ross E.,, McKinney, Texas 75070 (US); Devore, Joseph A.,, Dallas, Texas 75243 (US); Knight, Jonathan R.,, Dallas, Texas 75214 (US)
(74) Representative: Darby, David Thomas

(57) **Abstract**

An ESD protection circuit which includes high voltage and reference voltage terminals, an SCR circuit coupled between the terminals and a breakdown device (22) which becomes electrically conductive commencing at a predetermined voltage thereacross and coupled between the terminals to trigger conduction of the SCR circuit. The protection circuit protects a device to be protected coupled between the terminals, the predetermined voltage being a voltage below any voltage which will damage the device to be protected. The SCR circuit includes a PNP transistor (Q1) having an emitter coupled to the high voltage terminal, a base and a collector, an NPN transistor (Q2) having an emitter coupled to the reference voltage terminal, a base coupled to the collector of the PNP transistor (Q1) and a collector coupled to the base of the PNP transistor (Q1), a resistance (R1) between the high voltage terminal and the base of the PNP transistor (Q1) and a resistance (R2) between the reference voltage terminal and the base of the NPN transistor (Q2). The breakdown device (Z2) is a Zener diode. The Zener diode is coupled between the base of the PNP transistor (Q1) and the reference voltage terminal.

## Description

### FIELD OF THE INVENTION

This invention relates to an electrostatic discharge (ESD) protection circuit for use in conjunction with high voltage semiconductor component pins.

### BRIEF DESCRIPTION OF THE PRIOR ART

In analog design, there are frequent cases where some of the pins of an integrated circuit must operate at relatively high voltages during their normal operation. The problem of electrostatic discharge in such semiconductor devices and the problems caused by such discharges is well known and significant efforts have been made in the past to minimize the problems caused thereby. A solution to the ESD problem in high voltage transistors (i.e. wherein voltages on pins can run from about 50 to 100 volts) of the prior art has been to place a Zener diode between the pin and a reference voltage source. This can take the form, for example, of a Zener diode between a transistor source or drain connected to the high voltage pin and the transistor gate and a resistor from the transistor gate to the other of the transistor source and drain. The Zener diode is designed to have a breakdown voltage which is less than the breakdown voltage of the transistor being protected. Accordingly, when the voltage across the transistor exceeds the Zener breakdown voltage, the Zener diode will break down and cause the transistor to conduct, thereby preventing an excessively large voltage from existing across the transistor.

A problem with the above described solution to the ESD problem and with ESD protection circuitry in general has been that the transistor structures, such as, for example, with Zener diode as described hereinabove, occupies a very large amount of chip surface in order to create a structure that can withstand the ESD stress and the very large amount of power which must be dissipated. In practical circuits, such ESD structures require, for example, a width of about 3000 micrometers. With the continued miniaturization of semiconductor components, it is apparent that any minimization in area required for a semiconductor device that provides a predetermined set of parameters is essential.

SCR devices have also been used in the prior art for ESD protection. Such devices have not been successfully used in the prior art due to the inability to accurately control the firing voltages thereof at higher voltage levels (i.e. at about the 60 volt level).

### SUMMARY OF THE INVENTION

In accordance with the present invention, there is provided an ESD structure for high voltage semiconductor devices which accomplishes the above described goal and requires about one tenth or less chip area compared with the prior art structures.

Briefly, a Zener diode breakdown mechanism is used to trigger an SCR which is more efficient in handling current as well as requiring less energy to be dissipated in the integrated circuit than in the prior art. Prior art solutions use only a breakdown mechanism to dissipate the ESD strike. The ESD protection circuit herein remains off during normal high voltage operation, but will protect the pin and device coupled thereto from an ESD strike.

The ESD configuration in accordance with the present invention uses a breakdown mechanism to trigger an SCR device, which causes the voltage drop across the SCR device to be minimal. Because the voltage drop is minimal, the overall instantaneous power dissipation is much less than required in the prior art structures. Accordingly, less silicon area is required for the ESD protection circuit. In addition, the SCR circuits can carry more current per unit area than a junction breakdown mechanism, this feature also aiding in allowing the ESD structure to have reduced area.

### BRIEF DESCRIPTION OF THE DRAWINGS

The present invention will now be further described, by way of example, with reference to the accompanying drawings in which:-
FIGURE 1 is a circuit diagram of a typical high voltage ESD protection structure used in accordance with the prior art;
FIGURE 2 is a circuit diagram of a high voltage ESD protection circuit in accordance with the present invention;
FIGURE 3 is a cross-sectional view of an integrated circuit embodiment of the circuit of FIGURE 2; and
FIGURES 4a, 4b, 5, 6, 7, and 8 are circuit diagrams of high voltage ESD protection circuits in accordance with alternate embodiments of the present invention.

### DESCRIPTION OF THE PREFERRED EMBODIMENT

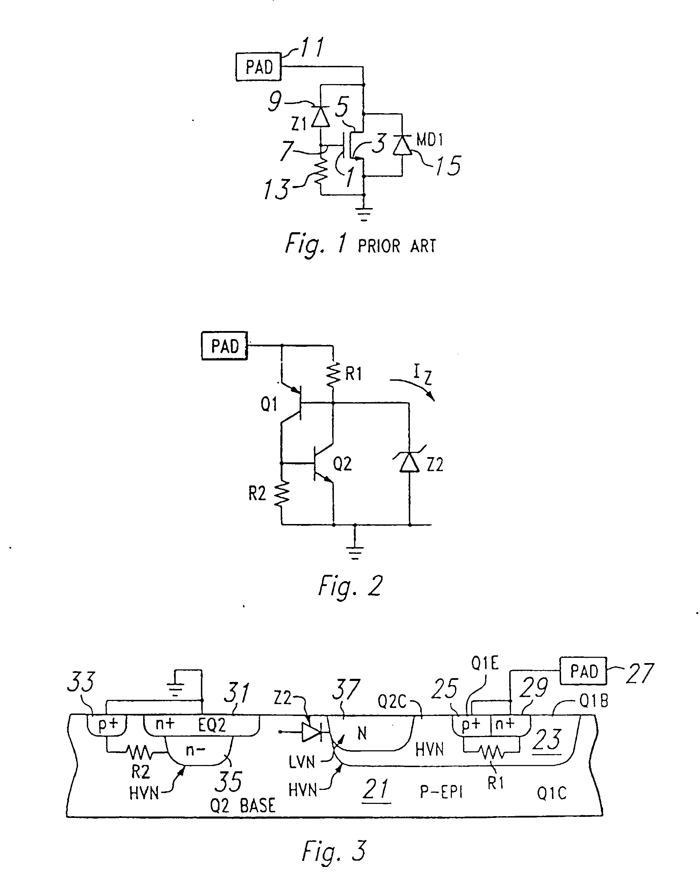

Referring first to FIGURE 1, there is shown a typical prior art high voltage ESD protection circuit which includes a DMOS transistor 1 having source 3, drain 5 and gate 7 connected between a pad or pin 11 and a source of reference voltage. A Zener diode 9 is coupled between the gate 7 and drain 5, the drain being coupled to the pad 11 which is coupled to V_{DD} or some other source capable of providing a high voltage. A resistor 13 is coupled between the gate 7 and the source 3 which is coupled to reference voltage. The diode 15 is a diode created in the semiconductor bulk as a result of formation of the DMOS transistor 1. The ESD protection mechanism used is the breakdown of the ESD device in the form of Zener diode 9 and resistor 13. The ESD stress is applied across the ESD protection circuit including diode 9 and resistor 13 which has, for example, a breakdown voltage of 60 volts. Because the ESD stress current is high (e.g. 1.3 amperes is typical for a 2kV, 1500 ohm Human body model test), the instantaneous power dissipation is very high across the ESD protection circuit (about 60 volts x 1.3 amperes = 78 watts in the example of the prior art provided). In order to have the ESD protection circuit survive an ESD stress, the structure must be made large enough that it can withstand the instantaneous power dissipated by the ESD strike.

Referring now to FIGURES 2 and 3, there is shown an ESD protection circuit in accordance with the present invention which is provided in a smaller area of silicon than the prior art protection circuit described above. The circuitry, as shown in FIGURE 2, includes an SCR which is composed of a PNP transistor Q1 having an emitter coupled to a source of high voltage via a pad or pin and a collector coupled to the base of NPN transistor Q2. The base of transistor Q1 is coupled to the collector of transistor Q2 with the emitter of transistor Q2 being coupled to a reference voltage source, such as ground. A resistor R1 is coupled between the emitter and base of transistor Q1 and a resistor R2 is coupled between the base and emitter of transistor Q2. A Zener diode Z2 is coupled between the base of transistor Q1 and the source of reference voltage.

The circuit of FIGURE 2 is shown in FIGURE 3 in an integrated circuit embodiment wherein the P-type epitaxial layer 21 comprises both the collector of transistor Q1 and the base of transistor Q2. Disposed within the layer 21 is a high voltage N-type well 23 which is the base of transistor Q1 and the collector of transistor Q2. A P+-type region 25 in the well 23 forms the emitter of transistor Q1 which is coupled to the pad or pin 27 along with an N+-type region 29 in the well 23 which provides the resistor R1. An N+-type region 31 in the layer 21 forms the emitter of transistor Q2 with resistor R2 being provided by a P+-type region 33 spaced from the N+-type region 31 and an N--type region 35 which is defused beneath the N+-type region 31. The Zener diode Z2 is provided by adding a low voltage N-type tank 37 within the high voltage N-type well 23 which also forms a junction with the layer 21. The P+-type region 33 and N+-type region 31 are coupled to a source of reference voltage whereas the pad 27 is coupled to a high voltage producing source.

In operation, with reference to FIGURE 2, as the voltage between the pin or pad and reference voltage increases, the emitter of transistor Q1 becomes forwardly biased relative to its base through resistor R1 and the potential at the base of transistor Q1 begins to rise. However, at this point there is very little current because there is nowhere for the current to flow until the breakdown voltage of Zener diode Z2 is reached. At this breakdown voltage point, current flow commences through resistor R1 and turns on transistor Q1 to apply base current to transistor Q2 and through resistor R2. This turns on transistor Q2 and causes even more base current to be pulled from transistor Q1 to rapidly protect against the electrostatic discharge on the pin or pad.

Transistors Q1 and Q2 together form the SCR structure. This structure along with Zener diode Z2 replaces the Zener diode Z1 of FIGURE 1 and requires substantially less, generally less than ten percent, of the semiconductor area required by the Zener diode Z1 of the prior art.

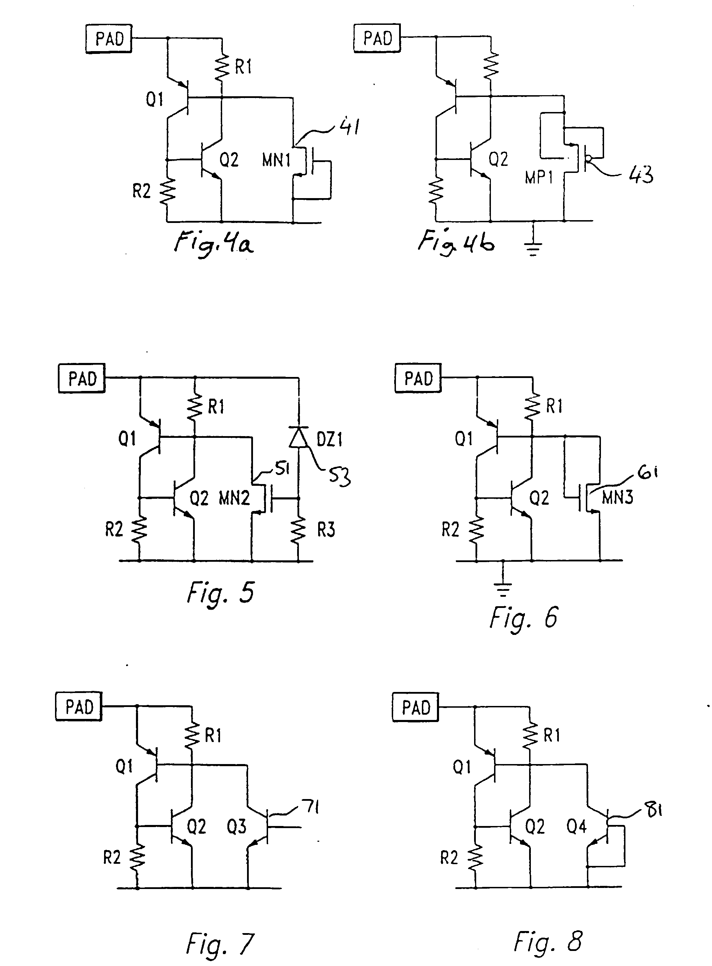

Zener diode Z2 can also be replaced by an NMOS device 41 with gate and source short circuited to ground as shown in FIGURE 4(a) or by a PMOS device 43 with gate and source coupled through resister R1 to the pad as shown in FIGURE 4(b) wherein all other components are the same as described above with reference to FIGURE 2. As a still further alternative, the Zener diode Z2 of FIGURE 2 can be replaced by a MOS device 51 with source-drain path in parallel with transistor Q2 and using another triggering mechanism, such as a Zener stack 53 with a resistor R3 coupled between the gate of MOS device 51 and ground, as shown in FIGURE 5 or the triggering mechanism could be a Vₜ of an MOS device 61 having a thick field as shown in FIGURE 6. An NPN bipolar device 71 with emitter coupled to ground as shown in FIGURE 7 or NPN bipolar device 81 with gate and emitter coupled to ground as shown in FIGURE 8 can also replace the Zener diode Z2. The Zener diode Z2 can also be replaced by a junction diode that is placed in a well different from that of the ESD structure.

Though the invention has been described with reference to a specific preferred embodiment thereof, many variations and modifications will immediately become apparent to those skilled in the art.

## Claims

1. An ESD protection circuit which comprises:
a high voltage terminal and a reference terminal;
an SCR circuit coupled between said terminal and said reference terminal; and
a breakdown device which becomes electrically conductive commencing at a predetermined voltage thereacross and coupled between said voltage terminal and said reference terminal to trigger conduction of said SCR circuit.

2. The circuit of Claim 1 further comprising; a device to be protected coupled between said voltage terminal and said reference terminal, said predetermined voltage being a voltage below any voltage which will damage said device to be protected.

3. The circuit of Claim 1 or Claim 2, wherein said breakdown device is a Zener diode.

4. The circuit of Claim 1 or Claim 2, wherein said breakdown device is a MOS device.

5. The circuit of Claim 1 or Claim 2, wherein said breakdown device is an NPN transistor.

6. The circuit of any preceding claim, wherein said SCR circuit includes a PNP transistor having an emitter coupled to said high voltage terminal, an NPN transistor having an emitter coupled to said reference voltage terminal, a base coupled to a collector of said PNP transistor and a collector coupled to a base of said PNP transistor, a resistance coupled between said high voltage terminal and said base of said PNP transistor and a resistance coupled between said reference voltage terminal and said base of said NPN transistor.

7. The circuit of Claim 3 to or Claim 6, wherein said Zener diode is coupled between said base of said PNP transistor and said reference voltage terminal.

8. The circuit of any of Claim 1 or Claim 2 or Claim 6, wherein said breakdown device is an NMOS device having a gate and a source coupled to said reference voltage terminal and having a current path coupled between said base of said PNP transistor and said reference voltage terminal.

9. The circuit of any of Claim 1 or Claim 2 or Claim 6, wherein said breakdown device is an PMOS device having a gate and a source coupled to said gate of said PNP transistor and having a current path coupled between said base of said PNP transistor and said reference voltage terminal.

10. The circuit of any of Claim 1 or Claim 2 or Claim 6, wherein said breakdown device is an NMOS device having a current path coupled between said base of said PNP transistor and said reference voltage terminal and a series connected diode and resistor coupled between said high voltage terminal and said reference voltage terminal, the gate of said NMOS device coupled to the junction of said diode and resistor.

11. The circuit of any of Claim 1 or Claim 2 or Claim 6, wherein said breakdown device is an NPN transistor with a current path coupled between said base of said PNP transistor and said reference voltage terminal.

12. The circuit of any of Claim 1 or Claim 2 or Claim 6, wherein said breakdown device is an NPN transistor with a current path coupled between said base of said PNP transistor and said reference voltage terminal and a gate coupled to said reference voltage terminal.
